# EUROPÄISCHE PATENTANMELDUNG

(11) **EP 4 617 623 A1**
(43) Veröffentlichungstag der Anmeldung: **17.09.2025**
(21) Anmeldenummer: 25162257.7
(22) Anmeldetag: 07.03.2025
(51) Int. Cl.: G01C 15/00, H01S 5/062

(54) **LASERGERÄT UND VERFAHREN ZUR STEUERUNG EINES SOLCHEN**

(30) Priorität: 11.03.2024 DE 102024106860
(71) Anmelder: STABILA Messgeräte Gustav Ullrich GmbH, 76855 Annweiler (DE)
(72) Erfinder: Busam, Daniel, 76829 Godramstein (DE); Kallabis, Gabriel, 76848 Spirkelbach (DE)
(74) Vertreter: Stoffregen, Hans-Herbert

(57) **Zusammenfassung**

Die Erfindung betriff ein Lasergerät (10) sowie ein Verfahren zur Steuerung eins solchen. Das Lasergerät (10) umfasst zumindest eine Laserdiode (14) zum Abstrahlen eines Laserstrahls (16, 20), eine Laserdiodensteuerung (24) zum Steuern zumindest des Betriebs der Laserdiode (14), einen Temperatursensor (32) zum Erfassen einer dem Lasergerät (10) zugeordneten Temperatur Ti, wie Innentemperatur des Lasernivellierungswerkzeugs, wobei die Laserdiodensteuerung (24) konfiguriert ist, um die zumindest eine Laserdiode (14) mit einer Betriebsleistung Pb zu betreiben und um die Betriebsleistung Pb der Laserdiode (14) auf eine reduzierte Betriebsleistung Pred zu reduzieren, wenn die erfasste Temperatur Ti einen Temperaturschwellwert Ts erreicht. Um die zumindest eine Laserdiode in einem optimalen Betriebspunkt zu betreiben, der zu einer unzulässigen Erwärmung nicht führt, ist vorgesehen, dass die Laserdiodensteuerung (24) derart konfiguriert ist, dass nach Reduzieren der Betriebsleistung Pb die Temperatur Ti in Zeitintervallen Δt mit dem Temperaturschwellwert Ts verglichen wird und die reduzierte Betriebsleistung Pred der Laserdiode (14) weiter reduziert wird, wenn die Temperatur Ti bei erfolgtem Vergleich größer als der Temperaturschwellwert Ts ist.

## Beschreibung

Die Erfindung betrifft ein Lasergerät, wie Lasernivellierungswerkzeug, mit zumindest einer Laserdiode zum Abstrahlen eines Laserstrahls, einer Laserdiodensteuerung zum Steuern zumindest des Betriebs der Laserdiode, einem Temperatursensor zum Erfassen einer dem Lasergerät zugeordneten Temperatur Ti, wie Innentemperatur des Lasergeräts wie Lasernivellierungswerkzeugs, wobei die Laserdiodensteuerung konfiguriert ist, um die zumindest eine Laserdiode mit einer Betriebsleistung Pb zu betreiben und um die Betriebsleistung Pb der Laserdiode auf eine reduzierte Betriebsleistung Pred zu reduzieren, wenn die erfasste Temperatur Ti einen Temperaturschwellwert Ts erreicht.

Ferner betrifft die Erfindung ein Verfahren zur Steuerung eines Lasergerätes, wie Lasernivellierungswerkzeug, umfassend die Verfahrensschritte:
Ansteuern zumindest einer Laserdiode mittels einer Laserdiodensteuerung zum Abstrahlen eines Laserstrahls,
Erfassen einer dem Lasergerät zugeordneten Temperatur Ti, wie Innentemperatur des Lasergeräts, wie Lasernivellierungswerkzeugs, mittels eines Temperatursensors, wobei die Laserdiodensteuerung die Laserdiode mit einer Betriebsleistung Pb betreibt und die Betriebsleistung Pb der Laserdiode auf eine reduzierte Betriebsleistung Pred reduziert wird, wenn die erfasste Temperatur Ti einen Temperaturschwellwert Ts erreicht.

Die EP 3 276 304 A1 (US 2018/0120103 A1) bezieht sich auf ein Lasernivellierungswerkzeug mit mindestens einer Laserdiode zum Abstrahlen eines Laserstrahls, einer Steuereinheit zum Steuern zumindest des Betriebs der Laserdiode und einem Wärmesensor zum Erfassen der Innentemperatur des Lasernivellierungswerkzeugs. Um einen weiteren Betrieb des Lasernivellierungswerkzeugs auch bei steigenden Temperaturen zu ermöglichen, ist vorgesehen, dass die Steuereinheit konfiguriert ist zum Verringern der Betriebsleistung der Laserdiode, wenn die erfasste Innentemperatur einen Temperaturschwellwert erreicht.

Dabei weist der Temperaturschwellwerte mindestens zwei verschiedene Temperaturschwellwerte auf, die unterschiedlichen Betriebsstrompegeln der Laserdiode entsprechen, wobei die Steuereinheit konfiguriert ist zum Verringern des Betriebsstroms der Laserdiode auf einen entsprechenden Betriebsstrompegel, wenn die erfasste Innentemperatur einen der Temperaturschwellwerte erreicht. Der Betriebsstrom der Laserdiode kann verringert werden, indem der Betriebszyklus oder der elektrische Strom der Laserdiode abgesenkt werden.

Die WO 2022/237285 A1 betrifft ein Verfahren zur Steuerung einer Laserdiode sowie ein entsprechendes Steuerungssystem. Um den Energieverbrauch der Laserdiode während des Betriebs zu reduzieren und um eine Überhitzung der Laserdiode während des Betriebs zu vermeiden, wird vorgeschlagen, dass die Laserdiode mit einer ersten Steuerspannung und einem ersten Tastverhältnis betrieben wird, wobei die Betriebszeit der Laserdiode erfasst wird und wobei dann, wenn die Betriebszeit der Laserdiode eine erste Zeitschwelle überschreitet, die Laserdiode mit einer zweiten Steuerspannung und einem zweiten Tastverhältnis betrieben wird, wobei die zweite Steuerspannung kleiner als die erste Steuerspannung ist und/oder das zweite Tastverhältnis kleiner als das erste Tastverhältnis ist.

Die EP 4 258 080 A1 bezieht sich auf eine Temperatursteuerung für eine Laserkomponente, wie Lasernivelliergerät. Dabei wird die Temperatur in eine Messspannung umgewandelt und mit einer Temperaturschwellenspannung verglichen, wobei die Leistung der Laserkomponente reduziert wird, wenn der Schwellwert überschritten wird.

Gegenstand der US 2024/0013017 A1 ist ein Kennzeichenlaser, wie Strichcodescanner. Um das Gerät auch in einer Umgebung nutzen zu können, bei der Temperaturen unter der Betriebstemperatur von Komponenten des Gerätes liegen, ist eine Stromquelle vorgesehen, mit der Strom erzeugt wird, der unterhalb der Laserschwelle des Geräts liegt.

Die WO 2021/103734 A1 bezieht sich auf eine Laserwasserwaage, die in einem weiten Arbeitstemperaturbereich benutzt werden kann.

Ein Verfahren zum Betreiben eines Infrarot-Sichtsystems für Kraftfahrzeuge ist Gegenstand der DE 10 2005 033 896 A1.

Der vorliegenden Erfindung liegt die Aufgabe zugrunde, eine Vorrichtung und ein Verfahren der eingangs genannten Art derart weiterzubilden, dass eine im Vergleich zum Stand der Technik vereinfachte Steuerung ermöglicht wird, die sicherstellt, dass die Betriebsleistung der Laserdiode zu einer unzulässigen Erwärmung nicht führt.

Die Aufgabe wird erfindungsgemäß im Wesentlichen gelöst durch ein Lasergerät, wie Lasernivellierungswerkzeug, umfassend: zumindest eine Laserdiode zum Abstrahlen eines Laserstrahls, eine Laserdiodensteuerung zum Steuern zumindest des Betriebs der Laserdiode, einen Temperatursensor zum Erfassen einer dem Lasergerät zugeordneten Temperatur Ti, wie Innentemperatur des Lasergeräts, wie Lasernivellierungswerkzeugs, wobei die Laserdiodensteuerung konfiguriert ist, um die zumindest eine Laserdiode mit einer Betriebsleistung Pb zu betreiben und um die Betriebsleistung Pb der Laserdiode auf eine reduzierte Betriebsleistung Pred zu reduzieren, wenn die erfasste Temperatur Ti einen Temperaturschwellwert Ts erreicht, wobei sich das Lasergerät dadurch auszeichnet, dass die Laserdiodensteuerung derart konfiguriert ist, dass nach dem Einschalten der Laderdiode oder nach dem erstmaligen Reduzieren der Betriebsleistung Pb die Temperatur Ti in Zeitintervallen Δt mit dem Temperaturschwellwert Ts verglichen wird und dass die Betriebsleistung Pred der Laserdiode dann reduziert wird, wenn die Temperatur Ti bei erfolgtem Vergleich gleich oder größer als der Temperaturschwellwert Ts ist.

Erfindungsgemäß ist vorgesehen, dass die Laserdiodensteuerung derart konfiguriert ist, dass nach Reduzieren der Betriebsleistung Pb die Temperatur Ti in vorzugsweise gleichen Zeitintervallen Δt mit dem Temperaturschwellwert Ts verglichen wird und dass die reduzierte Betriebsleistung Pred der Laserdiode dann reduziert wird, wenn die Temperatur Ti bei erfolgtem Vergleich größer als der Temperaturschwellwert Ts ist.

Der Erfindung liegt der Gedanke zugrunde, dass nur eine einzige Temperaturschwelle definiert und überwacht wird. Sobald die dem Lasergerät zugeordnete Temperatur, wie Innentemperatur des Lasergerätes, diese einzige Temperaturschwelle erreicht, wird die Betriebsleistung der Laserdiode reduziert.

Sodann erfolgen in Zeitintervallen, von z. B. 30 Minuten, weitere Temperaturmessungen. Liegt die gemessene Temperatur oberhalb der einzigen Temperaturschwelle, wird die Betriebsleistung der Laserdiode jeweils weiter reduziert, z. B. um 30 % der Nennleistung oder aktuellen Betriebsleistung der Laserdiode. Bei weiter ansteigender Temperatur insbesondere im Innern des Gehäuses des Lasergerätes, z. B. durch Umgebungseinflüsse, wird die Betriebsleistung der Laserdiode weiter reduziert werden, ggf. bis Null.

Sollte die Temperatur aufgrund der Reduzierung der Betriebsleistung nicht derart ansteigen, dass die Temperaturschwelle erreicht wird, so erfolgt eine Reduzierung nicht.

Die Erfindung sieht aber auch vor, dass nach dem Einschalten der Laserdiode in Zeitintervallen Δt, insbesondere 10 min ≤ Δt ≤ 60 min, die Temperatur Ti, die dem Lasergerät zugeordnet und somit ermittelt ist, mit dem Temperaturschwellwert Ts verglichen wird, und dass dann die Betriebsleistung Pred der Laserdiode dann reduziert wird, wenn die Temperatur Ti bei erfolgtem Vergleich gleich oder größer als der Temperaturschwellwert Ts ist.

Eine bevorzugte Ausführung zeichnet sich dadurch aus, dass die Laserdiodensteuerung ein Zeitglied zum Einstellen des Zeitintervalls Δt aufweist, wobei vorzugsweise Δt ≤ 60 min, insbesondere 10 min ≤ Δt ≤ 45 min, besonders bevorzugt Δt =30 min, ist, und/oder dass die Zeitintervalle Δt konstant oder variabel, vorzugsweise konstant, sind.

Der Temperaturschwellwert Ts liegt im Bereich Ts ≤ Tmax, insbesondere Ts < Tmax, vorzugsweise im Bereich 70% Tmax ≤ Ts ≤ 95% Tmax, wobei Tmax die maximal erlaubte Betriebstemperatur der Laserdiode ist.

Besonders bevorzugt weist die Laserdiodensteuerung eine Steuereinheit und einen Laserdiodentreiber auf, die konfiguriert sind, die Betriebsleistung Pb der Laserdiode in Stufen, linear oder entsprechend einer Funktion zu reduzieren.

Vorzugsweise erfolgt die Reduzierung der Betriebsleistung Pb in konstanten Leistungsreduzierungen oder in variablen Leistungsreduzierungen, wobei die variablen Leistungsreduzierungen erhöht werden, wenn eine Temperaturdifferenz ΔTis zwischen der oberhalb der Temperaturschwelle Ts liegenden gemessenen Temperatur Ti und dem Temperaturschwellwert Ts bei nacheinander erfolgendem Vergleichen der Temperaturen Ti, Ts steigt.

Vorzugsweise liegen die Leistungsreduzierungen im Bereich von 5% Pmax ≤ ΔPb ≤ 30% Pmax, mit Pmax als maximale Betriebsleistung der Laserdiode oder eingestellter Betriebsleistung der Laserdiode.

Vorzugsweise ist die Steuereinheit und/oder der Laserdiodentreiber derart konfiguriert, um die Amplitude des elektrischen Stroms und/oder der Spannung der Laserdiode und/oder eine Impulsbreite des elektrischen Stroms und/oder der Spannung einzustellen, insbesondere zu verringern.

Der Temperatursensor befindet sich vorzugsweise im Innern des Lasergerätes, insbesondere angrenzend an oder im Bereich der zumindest einen Laserdiode.

Ein Verfahren zur Steuerung eines Lasergeräts, wie Lasernivellierungswerkzeug, umfassend die Verfahrensschritte: Ansteuern zumindest einer Laserdiode mittels einer Laserdiodensteuerung zum Abstrahlen eines Laserstrahls, Erfassen einer dem Lasergerät zugeordneten Temperatur Ti, wie Innentemperatur des Lasernivellierungswerkzeugs, mittels eines Temperatursensors, wobei die Laserdiodensteuerung die Laserdiode mit einer Betriebsleistung Pb betreibt und die Betriebsleistung Pb der Laserdiode auf eine reduzierte Betriebsleistung Pred reduziert wird, wenn die erfasste Temperatur Ti einen Temperaturschwellwert Ts erreicht, zeichnet sich dadurch aus, dass nach dem Einschalten der Laderdiode oder nach dem erstmaligen Reduzieren der Betriebsleistung Pb die Temperatur Ti in Zeitintervallen Δt mit dem Temperaturschwellwert Ts verglichen wird und dass die Betriebsleistung Pred der Laserdiode dann reduziert wird, wenn die Temperatur Ti bei erfolgtem Vergleich gleich oder größer als der Temperaturschwellwert Ts ist.

Bevorzugterweise ist vorgesehen, dass die Reduzierung der Betriebsleistung Pb stufenweise, linear oder entsprechend einer vorgegebenen Funktion erfolgt und/oder dass die Reduzierung der Betriebsleistung Pb in konstanten oder variablen, vorzugsweise konstanten, Zeitintervallen Δt erfolgt.

Dabei ist insbesondere vorgesehen, dass die Reduzierung der Betriebsleistung Pb in konstanten Leistungsreduzierungen oder in variablen Leistungsreduzierungen erfolgt, wobei die variablen Leistungsreduzierungen erhöht werden, wenn eine Temperaturdifferenz ΔTis zwischen der oberhalb der Temperaturschwelle liegenden gemessenen Temperatur Ti und dem Temperaturschwellwert Ts bei nacheinander erfolgendem Vergleichen der Temperaturen Ti, Ts steigt.

Bevorzugt ist vorgesehen, dass die Leistungsreduzierung im Bereich von 5% Pmax ≤ ΔPb ≤ 50% Pmax liegt, mit Pmax als maximale Betriebsleistung der Laserdiode oder eingestellter Betriebsleistung der Laserdiode.

Vorzugsweise kann die Leistungsreduzierung als Funktion der Temperaturdifferenz der Temperaturdifferenz ΔTis erfolgen.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung eines bevorzugten Ausführungsbeispiels.

Es zeigen:
- Fig. 1: ein Prinzipschaltbild eines Lasernivellierungsgerätes,
- Fig. 2: ein Ablaufdiagramm einer Laserdiodensteuerung und
- Fig. 3: ein Diagramm der Innentemperatur des Lasernivellierungsgerätes und der Betriebsleistung der Laserdiode über der Zeit t.

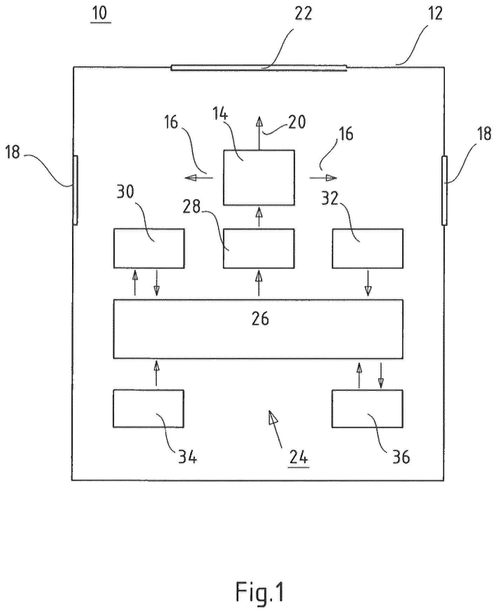

Fig. 1 zeigt ein Prinzipschaltbild eines Lasergerätes 10, insbesondere eines Lasernivellierungsgerätes, mit einem Gehäuse 12, in dem zumindest eine Laserdiode 14 angeordnet ist. Das Lasergerät 10 kann als Linienlaser betrieben werden, wobei ein oder mehrere von den Laserdioden 14 ausgehende Laserstrahlen 16 durch seitliche Austrittsfenster 18 austreten. Alternativ kann das Lasergerät 10 auch als Punktlaser betrieben werden, wobei ein von der Laserdiode 14 ausgehender Laserstrahl 20 als Lotstrahl das Gehäuse 12 über ein Austrittsfenster 22 verlässt.

Die zumindest eine Laserdiode 14 wird über eine Laserdiodensteuerung 24 betrieben. Diese umfasst eine Steuereinheit 26, einen Laserdiodentreiber 28 zum Betrieb der Laserdiode 14, ein Zeitglied 30 zur Einstellung eines Zeitintervalls Δt, einen Temperatursensor 32 zum Messen der Innentemperatur Ti des Gehäuses 12, eine Energieversorgung 34, wie Batterie oder Akku, zur Versorgung des Lasergerätes 10 mit Energie sowie eine Bedienungs- und Anzeigeeinheit 36.

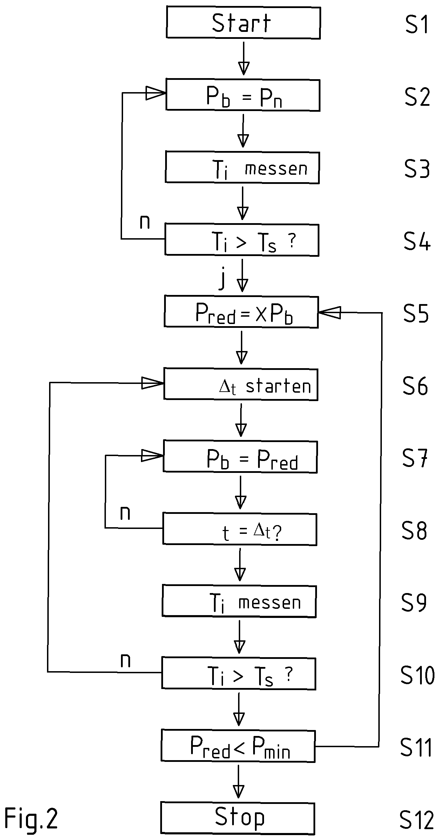

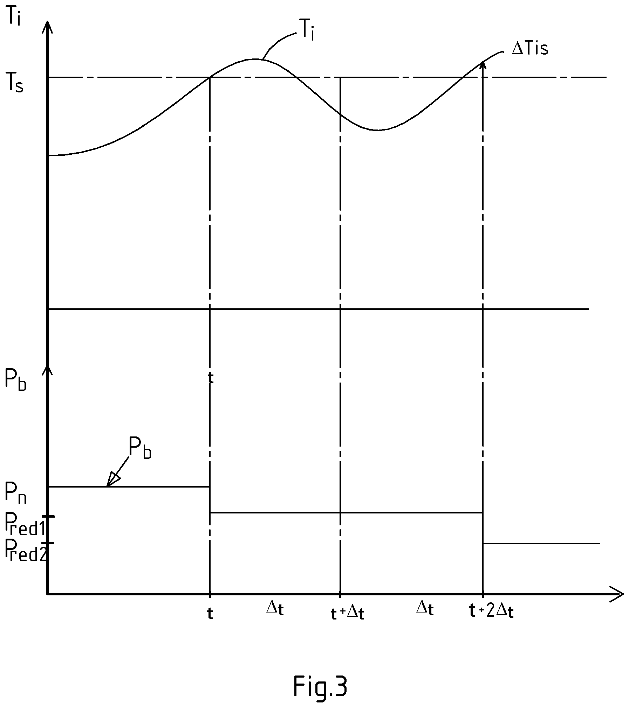

Die Funktion der Laserdiodensteuerung 24 sowie ein Verfahren zur Steuerung der Laserdiode 14 wird nachfolgend anhand des Ablaufdiagramms gemäß Fig. 2 und den Temperatur- und Leistungsdiagrammen gemäß Fig. 3 erläutert.

Fig. 2 zeigt ein Ablaufdiagramm eines Verfahrens zur Steuerung des Lasergerätes 10. Entsprechenden Temperatur- und Leistungsverläufe über die Zeit sind in Fig. 3 dargestellt. Nach dem Start des Lasergerätes 10 in Schritt S1 wird die Laserdiode 14 in Schritt S2 mit einer Betriebsleistung Pb betrieben, die vorzugsweise der Nennleistung Pn der Laserdiode 14 entspricht. Während des Betriebs wird die Temperatur Ti z.B. im Inneren des Gehäuses 12 mit dem Temperatursensors 32 gemessen (Schritt S3). Dabei wird die gemessene Temperatur Ti fortlaufend mit einem Temperaturschwellwert Ts verglichen (Schritt S4). Wenn die gemessene Temperatur Ti kleiner als der Temperaturschwellwert Ts ist, wird die Laserdiode 14 weiter mit Nennleistung Pn betrieben (Schritt S2).

Sobald die Temperatur Ti im Innern des Lasergerätes 10 erstmalig den Temperaturschwellwert Ts überschreitet, wird die Betriebsleistung Pb in Schritt S5 erstmalig auf eine erste reduzierte Betriebsleistung Pred1 reduziert.

Die Leistungsreduzierungen liegen im Bereich von 5% Pmax ≤ ΔPb ≤ 50% Pmax, mit Pmax als maximale Betriebsleistung der Laserdiode oder eingestellter Betriebsleistung der Laserdiode. Die Leistungsreduzierung kann in Abhängigkeit einer Temperaturdifferenz ΔTis zwischen der oberhalb der Temperaturschwelle Ts liegenden gemessenen Temperatur Ti und dem Temperaturschwellwert Ts eingestellt werden. Liegt die gemessene Temperatur Ti z. B. 5% über dem Temperaturschwellwert Ts kann die Leistungsreduzierung geringer eingestellt werden als bei einer gemessenen Temperatur Ti, die z. B. 10% über dem Temperaturschwellwert Ts liegt.

Gleichzeitig wird in Schritt S6 ein Zeitglied 30 gestartet, so dass die Laserdiode 14 zumindest über ein definiertes Zeitintervall Δt, z. B. 30 Min, mit der reduzierten Betriebsleitung Pred1 betrieben wird (Schritt S7). Nach Ablauf des Zeitintervalls Δt in Schritt S8 erfolgt in Schritt S9 eine Abfrage der aktuellen Temperatur Ti und in Schritt S10 ein Vergleich der aktuellen Temperatur Ti mit dem Temperaturschwellwert Ts. Sofern die Temperatur Ti kleiner als der Temperaturschwellwert Ts ist, wird das Verfahren durch erneutes Starten des Zeitgliedes 30 in Schritt S6 und Betrieb der Laserdiode mit der zuvor eingestellten reduzierten Betriebsleistung Pred1 weitergeführt. Mit anderen Worten erfolgt dann, wenn die Temperatur Ti aufgrund der Reduzierung der Betriebsleistung Pb nicht weiter ansteigt, eine weitere Reduzierung der Betriebsleistung Pb nicht.

Sollte jedoch in Schritt S10 festgestellt werden, dass die aktuelle Temperatur Ti, z. B. durch Umgebungseinflüsse, größer als die Temperaturschwelle Ts ist, wird das Verfahren in Schritt S5 weitergeführt, indem die bereits reduzierte Betriebsleistung Pred1 weiter um eine Leistungsreduzierung auf eine reduzierte Betriebsleistung Pred2 reduziert wird. Zuvor erfolgt in Schritt S11 eine Überprüfung, ob die reduzierte Betriebsleistung Pred größer als Null ist. Ansonsten wird in Schritt S12 die Laserdiode abgeschaltet.

Die Reduzierung der Betriebsleistung Pb erfolgt je nach Anwendung in konstanten Leistungsreduzierungen oder in variablen Leistungsreduzierungen.

Bei variablen Leistungsreduzierungen ist vorgesehen, dass die Leistungsreduzierungen erhöht werden, wenn eine Temperaturdifferenz ΔTis zwischen der oberhalb der Temperaturschwelle liegenden gemessenen Temperatur Ti und dem Temperaturschwellwert Ts steigt. Dabei liegen die Leistungsreduzierungen im Bereich von 5% Pmax ≤ ΔPb ≤ 30% Pmax, mit Pmax als maximale Betriebsleistung der Laserdiode oder eingestellter Betriebsleistung der Laserdiode.

Optimal erfolgt eine Reduzierung der Betriebsleistung Pb zunächst in kleinen Schritten, z. B. 5% Pmax. In Abhängigkeit der Temperaturdifferenz ΔTis zwischen der oberhalb der Temperaturschwelle liegenden gemessenen Temperatur Ti und dem Temperaturschwellwert Ts wird durch die Laserdiodensteuerung geregelt, ob die Leistungsreduzierung konstant bleibt oder erhöht wird. Auf diese Weise kann eine Selbstanpassung realisiert werden, so dass die Laserdiode mit der optimalen Helligkeit betrieben werden kann.

Aus Obigem ergibt sich, dass in Zeitintervallen Δt, von z. B. 30 min, Temperaturmessungen erfolgen. Liegt die gemessene Temperatur Ti oberhalb der einzigen Temperaturschwelle Ts, wird die Betriebsleistung Pb jeweils weiter reduziert. Bei weiter ansteigender Temperatur Ti, z. B. durch Umgebungseinflüsse, kann die Betriebsleistung Pb bis zu Null reduziert werden.

Der Temperaturvergleich unmittelbar nach vorgegebenen Zeitintervallen Δt kann jedoch auch nach dem Einschalten der Laserdiode erfolgen, also nicht erst dann, wenn erstmalig die gemessene Temperatur Ti zumindest gleich dem Temperaturschwellwert Ts ist.

## Patentansprüche

1. Lasergerät (10), wie Lasernivellierungswerkzeug, umfassend:
zumindest eine Laserdiode (14) zum Abstrahlen eines Laserstrahls (16, 20), eine Laserdiodensteuerung (24) zum Steuern zumindest des Betriebs der Laserdiode (14), einen Temperatursensor (32) zum Erfassen einer dem Lasergerät (10) zugeordneten Temperatur Ti, wie Innentemperatur des Lasergeräts, wie Lasernivellierungswerkzeugs, wobei die Laserdiodensteuerung (24) konfiguriert ist,
um die zumindest eine Laserdiode (14) mit einer Betriebsleistung Pb zu betreiben und um die Betriebsleistung Pb der Laserdiode (14) auf eine reduzierte Betriebsleistung Pred zu reduzieren, wenn die erfasste Temperatur Ti einen Temperaturschwellwert Ts erreicht,
**dadurch gekennzeichnet,**
**dass** die Laserdiodensteuerung (24) derart konfiguriert ist, dass nach dem Einschalten der Laderdiode oder nach dem erstmaligen Reduzieren der Betriebsleistung Pb die Temperatur Ti in Zeitintervallen Δt mit dem Temperaturschwellwert Ts verglichen wird und dass die Betriebsleistung Pred der Laserdiode (14) dann reduziert wird, wenn die Temperatur Ti bei erfolgtem Vergleich gleich oder größer als der Temperaturschwellwert Ts ist.

2. Lasergerät nach Anspruch 1,
**dadurch gekennzeichnet,**
**dass** die Laserdiodensteuerung (24) ein Zeitglied (30) zum Einstellen des Zeitintervalls Δt aufweist, wobei vorzugsweise Δt ≤ 60 min, insbesondere 10 min ≤ Δt ≤ 45 min, insbesondere Δt =30 min, ist und/oder dass die Zeitintervalle Δt konstant oder variabel, vorzugsweise konstant, sind.

3. Lasergerät nach Anspruch 1 oder 2,
**dadurch gekennzeichnet,**
**dass** der Temperaturschwellwert Ts im Bereich Ts ≤ Tmax, vorzugsweise 70% Tmax ≤ Ts ≤ 95% Tmax liegt, wobei Tmax die höchste erlaubte Betriebstemperatur der Laserdiode (14) ist.

4. Lasergerät nach zumindest einem der vorherigen Ansprüche,
**dadurch gekennzeichnet,**
**dass** die Laserdiodensteuerung (24) eine Steuereinheit (26) und einen Laserdiodentreiber (28) aufweist, die konfiguriert sind, die Betriebsleistung Pb der Laserdiode (14) in Stufen, linear oder entsprechend einer vorgegebenen Funktion zu verringern.

5. Lasergerät nach zumindest einem der vorherigen Ansprüche,
**dadurch gekennzeichnet,**
**dass** die Steuereinheit (26) und/oder der Laserdiodentreiber (28) konfiguriert ist bzw. sind, die Amplitude des elektrischen Stroms und/oder der Spannung der Laserdiode (14) und/oder eine Impulsbreite des elektrischen Stroms und/oder der Spannung einzustellen, insbesondere zu verringern.

6. Lasergerät nach zumindest einem der vorherigen Ansprüche,
**dadurch gekennzeichnet,**
**dass** der Temperatursensor (32) im Innern des Lasergerätes (10), insbesondere angrenzend an oder im Bereich der zumindest einen Laserdiode (14), angeordnet ist.

7. Verfahren zur Steuerung eines Lasergeräts (10), wie Lasernivellierungswerkzeug, umfassend die Verfahrensschritte:
Ansteuern zumindest einer Laserdiode (14) mittels einer Laserdiodensteuerung (24) zum Abstrahlen eines Laserstrahls (16, 20),
Erfassen einer dem Lasergerät (10) zugeordneten Temperatur Ti, wie Innentemperatur des Lasernivellierungswerkzeugs, mittels eines Temperatursensors (32),
wobei die Laserdiodensteuerung (24) die Laserdiode (14) mit einer Betriebsleistung Pb betreibt und die Betriebsleistung Pb der Laserdiode (14) auf eine reduzierte Betriebsleistung Pred reduziert wird, wenn die erfasste Temperatur Ti einen Temperaturschwellwert Ts erreicht,
**dadurch gekennzeichnet,**
**dass** nach dem Einschalten der Laderdiode oder nach dem erstmaligen Reduzieren der Betriebsleistung Pb die Temperatur Ti in Zeitintervallen Δt mit dem Temperaturschwellwert Ts verglichen wird und dass die Betriebsleistung Pred der Laserdiode (14) dann reduziert wird, wenn die Temperatur Ti bei erfolgtem Vergleich gleich oder größer als der Temperaturschwellwert Ts ist.

8. Verfahren nach Anspruch 7,
**dadurch gekennzeichnet,**
**dass** die Reduzierung der Betriebsleistung Pb stufenweise, linear oder entsprechend einer vorgegebenen Funktion erfolgt und/oder dass die Reduzierung der Betriebsleistung Pb in konstanten oder variablen, vorzugsweise konstanten, Zeitintervallen Δt erfolgt.

9. Verfahren nach Anspruch 7 oder 8,
**dadurch gekennzeichnet,**
**dass** die Reduzierung der Betriebsleistung Pb in konstanten Leistungsreduzierungen oder in variablen Leistungsreduzierungen erfolgt, wobei die variablen Leistungsreduzierungen erhöht werden, wenn eine Temperaturdifferenz ΔTis zwischen der oberhalb der Temperaturschwelle liegenden gemessenen Temperatur Ti und dem Temperaturschwellwert Ts steigt.

10. Verfahren nach zumindest einem der Ansprüche 7 bis 9,
**dadurch gekennzeichnet,**
**dass** die Leistungsreduzierung im Bereich von 5% Pmax ≤ ΔPb ≤ 50% Pmax liegt, mit Pmax als maximale Betriebsleistung der Laserdiode oder eingestellter Betriebsleistung der Laserdiode.

11. Verfahren nach zumindest einem der Ansprüche 7 bis 10,
**dadurch gekennzeichnet,**
**dass** die Leistungsreduzierung als Funktion der Temperaturdifferenz ΔTis erfolgt.
